# EUROPÄISCHE PATENTANMELDUNG

(11) **EP 0 621 634 A1**
(43) Veröffentlichungstag der Anmeldung: **26.10.1994**
(21) Anmeldenummer: 94104891.0
(22) Anmeldetag: 28.03.1994
(51) Int. Cl.: H01L 23/522

(54) **Spannungsversorgung für eine integrierte Halbleiteranordnung**

(30) Priorität: 21.04.1993 DE 4313053
(71) Anmelder: SIEMENS AKTIENGESELLSCHAFT, D-80333 München (DE)
(72) Erfinder: Lang, Alfred, Dipl.-Ing., D-81739 München (DE)

(57) **Zusammenfassung**

Bei integrierten Halbleiteranordnungen, die einen Bereich (6, 7) mit Schaltungselementen und einen Bereich (8) für die Verdrahtung der Schaltungselemente aufweisen, z.B. Standardzellen oder Gate-Arrays mit Verdrahtungskanälen, wird ein Ausgang (20, 21) einer Schaltstufe durch die Kapazität zwischen der Signalverbindungsleitung (20, ..., 25) und dem darunter liegenden Halbleitermaterial des Verdrahtungsbereichs (8) belastet. Der Verdrahtungsbereich (8) weist abwechselnd vorzugsweise gleich große p- und n-Dotierungsgebiete (26, ..., 30) auf, die jeweils an das negative bzw. positive Versorgungspotential (VSS, VDD) kontaktiert sind. Dadurch wird die am Ausgang wirksame Kapazität in etwa symmetrisch zu beiden Versorgungspotentialen (VDD, VSS) hin aufgeteilt. Somit werden der über die Spannungsversorgung zugeführte Teil des Umladestroms und durch diesen induzierte Störeinflüsse auf die Versorgungsspannung verringert.

## Beschreibung

Die Erfindung betrifft eine integrierte Halbleiteranordnung mit einem an ein erstes Versorgungspotential angeschlossenen Halbleitersubstrat von einem ersten Leitfähigkeitstyp, das einen ersten Bereich aufweist, in dem Schaltstufen angeordnet sind, und mindestens einen zweiten Bereich aufweist, in dem mindestens eine Verbindungsleitung zum Verbinden von Signalanschlüssen der Schaltstufen angeordnet ist, wobei im zweiten Bereich eine Vielzahl von Dotierungsgebieten mit einem zum ersten Leitfähigkeitstyp komplementären zweiten Leitfähigkeitstyp angeordnet ist, wobei die Dotierungsgebiete an ein zweites Versorgungspotential angeschlossen sind und wobei mindestens ein Teil der Gesamtfläche der Dotierungsgebiete unter der Verbindungsleitung liegt.

Eine solche integrierte Halbleiteranordnung ist aus der US-5,136,357 bekannt.

Bei integrierten Halbleiteranordnungen wirkt ein parasitärer Kondensator zwischen der Signalleitung, die den Ausgang einer Schaltstufe mit dem Eingang einer weiteren Schaltstufe verbindet, und dem Versorgungspotential, mit dem das Halbleitcrsubstrat kontaktiert ist. Beim Umschalten der Schaltstufe ändert sich der Pegel der Signalleitung von H nach L oder umgekehrt. Folglich wird auch der parasitäre Kondensator umgeladen. Bei derjenigen Signalflanke, bei der der Kondensator entladen wird, fließt der Entladestrom als Kurzschlußstrom über die zwischen die Kondensatorelektroden geschalteten Bauelemente. Bei derjenigen Signalflanke, bei der der Kondensator aufgeladen wird, wird der Ladestrom von der Versorgungsspannungsquelle der Halbleiteranordnung geliefert.

Wenn eine Vielzahl von Schaltstufen synchron umschaltet, kann ein derart hoher Stromimpuls auf den Verbindungsleitungen zwischen der Versorgungsspannungsquelle und den auf der Halbleiteranordnung integrierten Schaltstufen entstehen, daß die parasitären Induktivitäten der Verbindungsleitungen wirksam werden und impulsförmige Spannungen daran abfallen. Während des Umschaltvorgangs sinkt dann die an den Schaltstufen anliegende Versorgungsspannung. Dadurch wird die Störsicherheit der Signale verringert. Die parasitären Induktivitäten wirken dem Stromimpuls entgegen, so daß zum Umladen der parasitären Kapazitäten der mit den Schaltstufen ausgangsseitig verbundenen Signalleitungen ein geringerer Strom zur Verfügung steht. Die Signallaufzeit wird dann erhöht.

Bei einer aus der US-5,136,357 bekannten integrierten Halbleiteranordnung wird der Einfluß der an der Signalleitung wirksamen parasitären Kapazitäten dadurch verringert, daß im zweiten Bereich eine Vielzahl von Dotierungsgebieten mit einem zum ersten Leitfähigkeitstyp komplementären zweiten Leitfähigkeitstyp angeordnet ist, daß die Dotierungsgebiete an ein zweites Versorgungspotential angeschlossen sind und daß mindestens ein Teil der Gesamtfläche der Dotierungsgebiete unter der Verbindungsleitung liegt.

Allerdings sind bei der bekannten Kalbleiteranordnung die ersten Bereiche beliebig über das Substrat verteilt, so daß für jede vorkommende Verbindungsleitung ein geeignet liegendes Dotierungsgebiet geschaffen werden muß, wodurch dann zwangsläufig auch die Dotierungsgebiete beliebig über das Substrat verteilt sind. Dadurch entsteht ein erheblicher Aufwand bei der Umsetzung der jeweiligen, in der Halbleiteranordnung realisierten Schaltung in Masken für den Fertigungsprozeß.

Der Erfindung liegt somit die Aufgabe zugrunde, dieses Problem zu vermeiden und eine Verteilung der ersten und zweiten Bereiche anzugeben, die für beliebige Schaltungen verwendet werden kann.

Die Aufgabe wird bei einer integrierten Halbleiteranordung gemäß dem Oberbegriff des Anspruchs 1 dadurch gelöst,daß der erste und der zweite Bereich streifenförmig ausgebildet sind, daß der erste und der zweite Bereich an ihrer Längsseite aneinander grenzen, daß jedes Dotierungsgebiet des zweiten Bereichs sich über die Breite des zweiten Bereichs erstreckt und daß jeweils zwischen zwei Dotierungsgebieten ein Abschnitt des Halbleitersubstrats vom ersten Leitfähigkeitstyp liegt.

Ein Vorteil dieser erfindungsgemäßen Anordnung ist, daß nur in den zweiten Bereichen Dotierungsgebiete vorgesehen werden müssen und diese zweiten Bereiche an festgelegten Stellen liegen.

Die Erfindung wird im folgenden anhand der in der Zeichnung dargestellten Figuren naher erläutert. Es zeigen:
- Figur 1: die Aufsicht auf einen integrierten Halbleiterchip,
- Figur 2: eine erfindungsgemäße Anordnung der p- und n-Dotierungsgebiete in einem Verdrahtungskanal und
- Figur 3: ein elektrisches Ersatzschaltbild eines Teils der Anordnung der Figur 2.

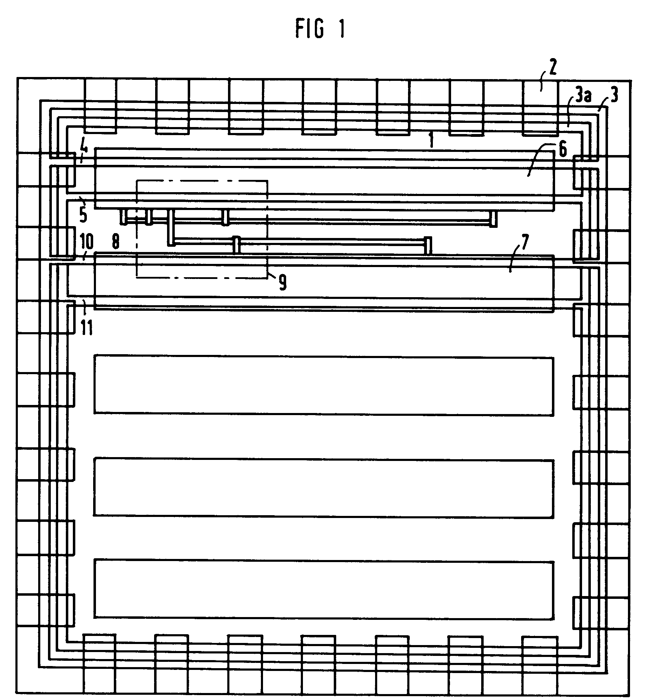

Der in der Figur 1 gezeigte Halbleiterchip ist beispielsweise eine in CMOS-Technik realisierte integrierte Schaltung. Auf dem N-dotierten Substrat 1 sind die signalverarbeitenden Schaltstufen aus n-Kanal-MOS-Transistoren und p-Kanal-MOS-Transistoren, die Versorgungsleitungen für das Versorgungspotential VDD und das dazu negative Versorgungspotential VSS sowie die die Schaltstufen an ihren Ein- und Ausgängen verbindenden Signalleitungen gezeigt. Im einzelnen enthält der Chip an seinem Rand Peripheriezellen 2 zur Aufbereitung der Ein- und Ausgabesignale sowie zum Anschluß der VersorgungsSpannung. Über die Peripheriezellen 2 verlaufen mindestens zwei Versorgungsleitungen 3, 3a die je ein Versorgungspotential führen. Im inneren Bereich des Chips sind Bereiche 6, 7 mit signalverarbeitenden Schaltungsteilen angeordnet. Zwischen den Bereichen 6, 7 liegt ein Bereich 8, in dem Signalverbindungsleitungen verlaufen, mit denen die signalverarbeitenden Schaltstufen innerhalb eines oder verschiedener signalverarbeitender Bereiche verbunden werden. Die Schaltstufen der signalverarbeitenden Bereiche 6, 7 werden über je eine Leitung 4, 10 bzw. 5, 11 für das Versorgungspotential VDD und das Versorgungspotential VSS mit Spannung versorgt. Diese sind an die entsprechende der Leitungen 3, 3a der Chipperipherie angeschlossen.

In den Bereichen 6, 7 sind die entsprechenden Dotierungsgebiete für die Kanalbereiche und Drain- und Source-Gebiete der MOS-Transistoren angeordnet. Ein p-Kanal-MOS-Transistor wird im n-Substrat realisiert, ein n-Kanal-MOS-Transistor in einer im Substrat eingebrachten p-Wanne. Die Halbleiteranordnung kann beispielsweise in Standardzellen-Technik realisiert sein. Dort werden in ihrer Funktion vordefinierte Zellen gemäß den Bereichen 6, 7 zeilenartig aneinandergereiht.

Jede Zelle enthalt Transistoren, die innerhalb der Zelle gemäß der zu erzeugenden Schaltungsfunktion verdrahtet sind. Entsprechend der vom Anwender gewünschten Funktion des gesamten Chips werden die Zellen mit im Verdrahtungskanal angeordneten Verbindungsleitungen untereinander verbunden. Die Anordnung der Figur 1 kann auch in Gate Array-Entwurfstechnik erzeugt werden. Hier wird bereits von in das Substrat 1 in den Bereichen 6, 7 angeordneten unverbundenen Transistoren ausgegangen, die dann zur Erzeugung von Zellen, die jeweils eine bestimmte Schaltfunktion ausführen, lokal innerhalb der Bereiche 6, 7 verdrahtet werden. Die Signalverbindung zwischen verschiedenen Zellen wird mittels Verbindungsleitungen in den Verdrahtungskanälen 8 erzeugt.

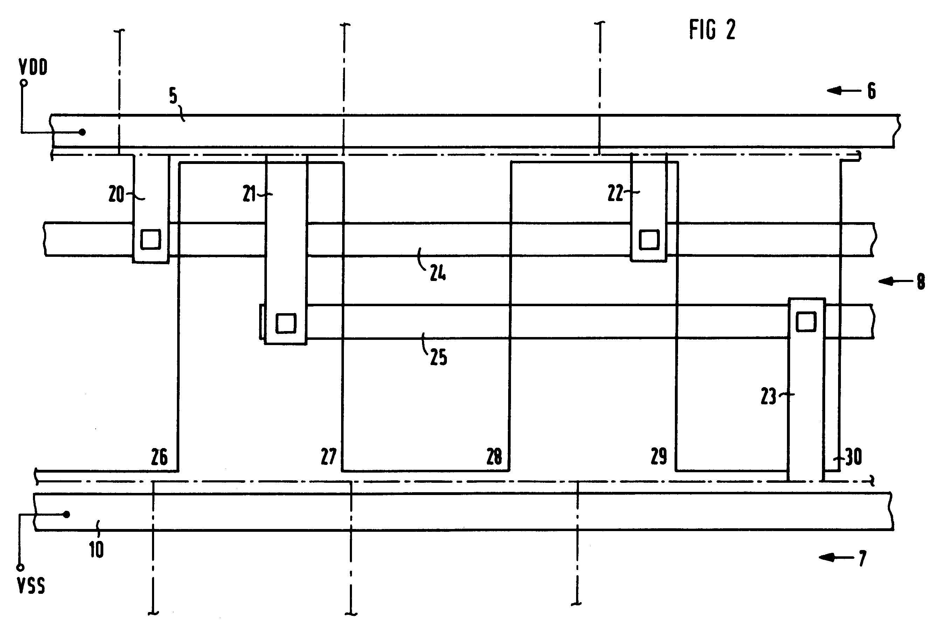

Ein Ausschnitt 9, der einen Teil des Verdrahtungskanals 8 mit den angrenzenden Bereichen 6, 7 enthält, ist detailliert in der Figur 2 gezeigt. Leiterbahnabschnitte 20, ..., 23 von in den Bereichen 6, 7 angeordneten Schaltstufen reichen in den Verdrahtungskanal 8 hinein. Sie sind über dazu senkrecht verlaufenden Leiterbahnabschnitte 24, 25 miteinander verbunden. Der Leiterbahnabschnitt 20 ist beispielsweise der Ausgang einer Schaltstufe, der über die Leiterbahnabschnitte 24, 22 mit dem Eingang einer weiteren Schaltstufe im Bereich 6 verbunden ist. In entsprechender Weise sind über die Leitungsabschnitte 21, 25, 23 die Ein- und Ausgänge von Schaltstufen der Bereiche 6, 7 verbunden. Im Verdrahtungskanal 8 wechseln n-Substratbereiche 26, 28, 30 mit p-Wannenbereichen 27, 29 ab. Die Bereiche 6, 7 mit den signalverarbeitenden Schaltungsteilen sind üblicherweise derart aufgebaut, daß die n-Kanal-Transistoren des Bereichs 7 und die p-Kanal-Transistoren des Bereichs 6 in unmittelbarer Nähe des Verdrahtungskanals 8 angeordnet sind. Dies bedeutet, daß im Bereich 6 das n-Substratgebiet bis an den Kanal 8 reicht, im Bereich 7 das p-Wannengebiet. Dabei gehen die p-Wannen 27, 29 des Verdrahtungskanals 8 in das p-Wannengebiet des Bereichs 7 über. Ebenso hängen die n-Gebiete 26, 28, 30 des Verdrahtungskanals 8 und die n-Gebiete des Bereichs 6 zusammen. Das n-Substratgebiet des Bereichs 6 ist durch eine Vielzahl von Kontakten mit der Versorgungsleitung 5 verbunden und somit an das Versorgungspotential VDD gelegt. Das p-Wannengebiet des Bereichs 7 ist über die Versorgungsleitung 10 an das Versorgungspotential VSS angeschlossen. Somit ist auch gewährleistet, daß die p-n-Übergänge zwischen den Gebieten 26, ..., 30 des Verdrahtungskanals 8 eine in Sperrrichtung gepolte Diode bilden.

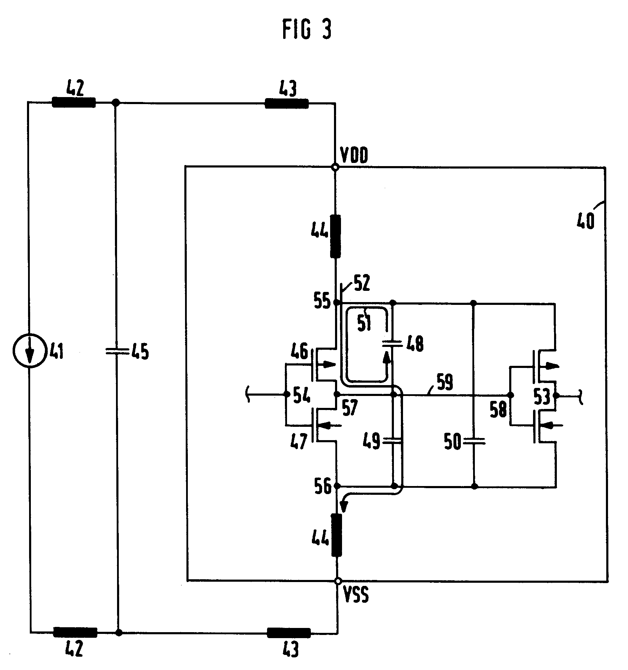

Ein elektrisches Ersatzschaltbild eines Teils der Figur 2 ist zur Erläuterung der Funktionsweise in Figur 3 gezeigt. Ein integrierter Halbleiterchip 40 wird von einer Spannungsquelle 41 versorgt. In den jeweiligen Anschlußleitungen für die Versorgungspotentiale VDD, VSS sind die parasitären Induktivitäten 42, 43, 44 wirksam. Die Wirkung der Induktivität 42, die beispielsweise in den Leiterbahnen einer gedruckten Schaltung vorliegt, wird durch einen Kondensator 45 ausgeglichen. Hierzu liefert die im Kondensator 45 enthaltene Ladung mindestens einen Teil des vom Halbleiterchip 40 aufgenommenen Stromimpulses. Dieser Teil des Stromimpulses bewirkt keinen Spannungsabfall an den Induktivitäten 42. Man spricht davon, daß die Spannung am betreffenden Abschnitt der Versorgungsspannungszuführungen gestützt wird. Die danach folgenden parasitären Induktivitäten 43, 44 zwischen dem Anschlußpunkt des Stützkondensators 45 und den Versorgungsanschlüssen 55, 56 der integrierten Schaltstufen entstehen hauptsächlich durch Gehäuse-Pins und Bond-Drähte.

Diese Induktivitäten werden nicht durch den Stützkondensator 45 ausgeglichen. An die Versorgungsspannung ist innerhalb der integrierten Schaltung ein Inverter aus komplementären MOS-Transistoren 46, 47 angeschlossen. Dieser Inverter ist beispielsweise im Bereich 6 des Layouts der Figur 2 angeordnet. Sein Ausgang 57 ist mit dem Eingang 58 eines weiteren Inverters 53 verbunden, der ebenfalls im Bereich 6 angeordnet ist. Ausgangsanschluß 57 und Eingangsanschluß 58 sind über die im Verdrahtungskanal 8 verlaufende Leitung 59 verbunden. Dabei entsprechen die Anschlüsse 57, 58 den mit den Leitungen 20, 22 verbundenen Anschlüssen der Figur 2, die Leitung 59 der Leitung 24 der Figur 2. Zwischen dem Ausgang 57 und dem Versorgungspotential VDD wirkt die parasitäre Kapazität 48, zwischen dem Ausgang 57 und dem Versorgungspotential VSS die parasitäre Kapazität 49. In den Kapazitäten 48, 49 sind die längs der Leitungen 20, 24, 22 verteilten Kapazitäten gegenüber den an das positive Versorgungspotential VDD angeschlossenen n-Substratgebieten 26, 28 bzw. den an das negative Versorgungspotential VSS angeschlossenen p-Wannenbereichen 27, 29 enthalten.

Mit den Bezugszeichen 51, 52 sind die Umladeströme bezeichnet, die bei einem Umschaltvorgang des Ausgangssignals des Inverters 54 beispielsweise von einem L-Pegel zu einem H-Pegel fließen. Hierbei wird die parasitäre Kapazität 48 entladen, die parasitäre Kapazität 49 aufgeladen. Der Entladeststrom der Kapazität 48 fließt intern im Chip über den Transistor 46. Der Ladestrom der Kapazität 49 wird von den Versorgungsanschlüssen 55, 56 für die Versorgungspotentiale VDD, VSS geliefert.

Wenn die sich abwechselnden Substrat- und Wannengebiete im Verdrahtungskanal gleich groß sind, haben auch die parasitären Kapazitäten 48, 49 etwa gleich große Werte. Im Vergleich zu herkömmlichen Halbleiteranordnungen ist der Wert derjenigen Kapazität, die beim Umschaltvorgang über den von der Versorgungsquelle gelieferten Strom umgeladen wird, in etwa halbiert. Folglich ist auch der Umladestrom geringer. Deshalb sind auch die Störeinflüsse der in den Zuleitungen wirksamen parasitären Induktivitäten auf die VersorgungsSpannung geringer.

Die p-n-Übergänge an den Grenzschichten der n-Substratgebiete 26, 28, 30 und p-Wannengebiete 27, 29 bilden eine Diffusionskapazität, die zwischen den Versorgungspotentialen VDD, VSS liegt. In der Figur 3 ist diese Diffusionskapazität als Kapazität 50 zwischen den Versorgungspotentialen VDD, VSS geschaltet. Die Diffusionskapazität 50 wirkt vorteilhafterweise als Stutzkapazität, durch die die Wirkung der parasitären Induktivitäten 43, 44 zumindest zum Teil ausgeglichen wird.

## Patentansprüche

1. Integrierte Halbleiteranordnung mit einem an ein erstes Versorgungspotential (VDD) angeschlossenen Halbleitersubstrat (1) von einem ersten Leitfähigkeitstyp, das einen ersten Bereich (6) aufweist, in dem Schaltstufen angeordnet sind, und mindestens einen zweiten Bereich (8) aufweist, in dem mindestens eine Verbindungsleitung zum Verbinden von Signalanschlüssen der Schaltstufen (20, ..., 25) angeordnet ist,
wobei im zweiten Bereich (8) eine Vielzahl von Dotierungsgebieten (27, 29) mit einem zum ersten Leitfähigkeitstyp komplementären zweiten Leitfähigkeitstyp angeordnet ist, wobei die Dotierungsgebiete an ein zweites Versorgungspotential (VSS) angeschlossen sind und wobei mindestens ein Teil der Gesamtfläche der Dotierungsgebiete unter der Verbindungsleitung liegt.
**dadurch gekennzeichnet,**
daß der erste und der zweite Bereich (6, 8) streifenformig ausgebildet sind,
daß der erste und der zweite Bereich (6, 8) an ihrer Längsseite aneinander grenzen,
daß jedes Dotierungsgebiet (27, 29) des zweiten Bereichs (8) sich über die Breite des zweiten Bereichs erstreckt und daß jeweils zwischen zwei Dotierungsgebieten (27, 29) ein Abschnitt des Halbleitersubstrats vom ersten Leitfähigkeitstyp liegt.

2. Integrierte Halbleiteranordnung nach Anspruch 1,
**dadurch gekennzeichnet,** daß die Dotierungsgebiete (27, 29) rechteckig sind und gleiche Abmessungen haben und daß die Abstände der Dotierungsgebiete (27, 29) voneinander gleich der Länge der Dotierungsgebiete (27, 29) sind.

3. Integrierte Halbleiteranordnung nach Anspruch 2,
**dadurch gekennzeichnet,** daß der erste Bereich (6) an der Längsseite ein sich über die Länge der Längsseite erstrekkendes Dotierungsgebiet vom zweiten Leitfähigkeitstyp aufweist und daß die Dotierungsgebiete des ersten und zweiten Bereichs (6, 8) zusammenhängen.
